# EUROPEAN PATENT APPLICATION

(11) **EP 4 080 229 A1**
(43) Date of publication of application: **26.10.2022**
(21) Application number: 20902279.7
(22) Date of filing: 18.11.2020
(51) Int. Cl.: G01R 31/34, H02N 1/04

(54) **METHOD FOR ANALYZING ELECTRIC SIGNAL OF TRIBOELECTRIC POWER GENERATING DEVICE**

(30) Priority: 17.12.2019 KR 20190168478
(71) Applicant: Song, Charles Kiseok, Seoul 04189 (KR)
(72) Inventor: Song, Charles Kiseok, Seoul 04189 (KR)
(74) Representative: dompatent von Kreisler Selting Werner - Partnerschaft von Patent- und Rechtsanwälten mbB
(86) International application number: PCT/KR2020/016285
(87) International publication number: WO 2021/125583

(57) **Abstract**

Disclosed is an electrical signal analysis method of a triboelectric power generating device capable of evaluating objectively and equally the performance between power generating devices by using multiple analysis methods capable of evaluating the performance of the triboelectric power generating device. The electric signal analysis method of the triboelectric power generating device includes analyzing electrical signals of the triboelectric power generating device through at least one of the following protocols a) to d): a) a protocol that analyzes electrical signals generated by applying a force to the center at a certain period so that the triboelectric power generating device is bent; b) a protocol that analyzes electrical signals generated by applying a force to at least one end so that the triboelectric power generating device is bent; c) a protocol that that analyzes electrical signals generated by tapping the device at a certain period or causing vibration to the device within a limit without converting a shape of the triboelectric power generating device; and d) a protocol that analyzes electrical signals generated by shaking an inducer spaced apart from the triboelectric power generating device at a predetermined distance.

## Description

### [Technical Field]

This application claims priority to and the benefit of Korean Patent Application No. 10-2019-0168478 filed in the Korean Intellectual Property Office on December 17, 2019, the entire contents of which are incorporated herein by reference.

The present invention relates to an electrical signal analysis method of a triboelectric power generating device, and more particularly, to an electrical signal analysis method of a triboelectric power generating device capable of objectively and equally evaluating the performance between power generation devices by using multiple analysis methods capable of evaluating the performance of the triboelectric power generating device.

### [Background Art]

A triboelectric power generating device is generally to use a triboelectric effect in which electric charge transfer occurs when two materials with different triboelectric polarities are in contact with each other, and recently, there is a growing trend of methods capable of producing electricity with high efficiency through various energy sources such as human physical movements or mechanical vibration. As described above, as the performance of triboelectric power generating devices is improved, some protocols capable of comparing and evaluating the performance of these power generating devices are also known, and as long as the performance comparison between the devices through these protocols is made smoothly, it is determined that the protocols are very useful used in the art.

However, in the existing protocols, since methods of evaluating triboelectric power generating devices are different from each other or are not standardized, the performance evaluation between the devices cannot be implemented under objective and equal conditions, and as a result, there is a problem in that it is difficult to compare and contrast the performance between the triboelectric power generating devices. Accordingly, there is a need to develop novel analysis protocols capable of evaluating the performance between devices under objective and equivalent conditions by standardizing the method for evaluating the performance of the triboelectric power generating device.

### [Disclosure]

### [Technical Problem]

Therefore, an object of the present invention is to provide an electrical signal analysis method of a triboelectric power generating device capable of evaluating objectively and equally the performance between power generating devices by using multiple analysis methods capable of evaluating the performance of the triboelectric power generating device.

### [Technical Solution]

In order to achieve the above object, the present invention provides an electric signal analysis method of a triboelectric power generating device including analyzing electrical signals of a triboelectric power generating device through at least one of the following protocols a) to d): a) a protocol that analyzes electrical signals generated by applying a force to the center at a certain period so that the triboelectric power generating device is bent; b) a protocol that analyzes electrical signals generated by applying a force to at least one end so that the triboelectric power generating device is bent; c) a protocol that analyzes electrical signals generated by tapping the device at a certain period or causing vibration to the device within a limit without converting a shape of the triboelectric power generating device; and d) a protocol that analyzes electrical signals generated by shaking an inducer spaced apart from the triboelectric power generating device at a predetermined distance.

### [Advantageous Effects]

According to the present invention, the electric signal analysis method of the triboelectric power generating device has an advantage of objectively and equally evaluating the performance between the power generating devices by using multiple analysis methods capable of evaluating the performance of the triboelectric power generating device.

### [Description of Drawings]

FIGS. 1 to 5 are graphs of electrical signals of a triboelectric power generating device which are measured using protocols a) to d) according to an embodiment of the present invention.
FIG. 6 is a graph of electrical signals of a triboelectric power generating device which are measured using a hand according to Comparative Example.

### [Best Mode]

Hereinafter, the present invention will be described in detail.

An electric signal analysis method of a triboelectric power generating device includes analyzing electrical signals of a triboelectric power generating device through at least one of the following protocols a) to d):
a) a protocol that analyzes electrical signals generated by applying a force to the center at a certain period so that the triboelectric power generating device is bent;
b) a protocol that analyzes electrical signals generated by applying a force to at least one end so that the triboelectric power generating device is bent;
c) a protocol that that analyzes electrical signals generated by tapping the device at a certain period or causing vibration to the device within a limit without converting a shape of the triboelectric power generating device; and
d) a protocol that analyzes electrical signals generated by shaking an inducer spaced apart from the triboelectric power generating device at a predetermined distance.

As described above, some existing protocols for evaluating the performance of the triboelectric power generating device have been known. However, since methods of evaluating these triboelectric power generating devices are different from each other or are not standardized, the performance evaluation between the devices cannot be implemented under objective and equal conditions, and as a result, there is a problem in that it is difficult to compare and contrast the performance between the triboelectric power generating devices. Accordingly, there is a need to develop novel analysis protocols capable of evaluating the performance between devices under objective and equivalent conditions by standardizing the method for evaluating the performance of the triboelectric power generating device.

That is, the four electrical signal analysis protocols a to d are to induce apple-to-apple performance evaluation between devices, and are based on a method which exerts directly or indirectly a physical effect on the triboelectric power generating device and interprets electrical signals generated by the physical effect. On the other hand, as the triboelectric power generating device that may be applied to the electric signal analysis method of the triboelectric power generating device according to the present invention, there is no limitation so long as the triboelectric power generating device uses a triboelectric effect in which two materials having different triboelectric polarities come into contact with each other so that charge transfer occurs. For example, a power generating device that can convert all physical kinetic energy applied from the outside into electrical energy and can be used for wind power generation, tidal power generation, and wave power generation, and even a power generating device that can detect physical movements, or detect texture, hardness, or a force to be applied to be used as a sensor can be applied to the electric signal analysis method of the present invention. In addition, it goes without saying that the triboelectric power generating device of Korean Patent Application No. 10-2017-0156387 filled on November 22, 2017 by the present applicant may also be applied to the electric signal analysis method of the present invention.

Hereinafter, the protocols a) to d) will be described in detail.

### 1. Protocol a)

First, the electrical signal analysis protocol of a) is a method of analyzing electrical signals generated by tapping and bending the center of the triboelectric power generating device with a predetermined force and period. That is, in order to generate the electric signals, it is necessary to have a physical effect on the triboelectric power generating device as described above (that is, a physical effect of bending the device by tapping the device with a predetermined force), and in order to measure and analyze the generated electric signals, it is necessary to connect a signal analysis device to each electrode. The signal analysis device is not particularly limited as long as the device is a device capable of analyzing electrical signals, and may include, for example, a graphic sampling multimeter, such as Keithley DMM 7510.

In addition, in order to measure more accurate electrical signals by blocking external static electricity, that is, to induce a Faraday cage effect, the triboelectric power generating device may be provided inside a substrate made of a conductive material or surrounded by a conductor. Here, the form of the substrate may include a box type, a mesh type, etc., and the conductor surrounding the device may be a plate-shaped conductive metal such as aluminum foil (alternatively, including aluminum foil).

In addition, when analyzing the electric signals, a pair of bars (or rods) for applying a force to the center of the triboelectric power generating device at a certain period may be provided to be spaced apart at a predetermined interval from or bonded to the upper and lower portions of the triboelectric power generating device. That is, one bar of the pair of bars may be positioned in an upper direction of the triboelectric power generating device, and the other bar may be positioned in a lower direction of the triboelectric power generating device, wherein the pair of bars are spaced apart at a certain distance from or bonded to the device and need to be placed in upper and lower directions of the center of the device.

On the other hand, there is no particular limitation on the size of the bar and the separation distance from the device, and for example, the diameter of the bar may be 5 to 20 mm, and in case of separation, each bar may be spaced apart from the device by 0.5 to 5 mm. As long as the force may be applied to the center of the triboelectric power generating device through the bar, there is no particular limitation on the size of the bar and the separation distance from the device as described above. There is no particular limitation as long as the material of the bar may also bend the device by applying a force to the center of the device, but considering that the device should not be broken while applying a physical impact at high speed (more than 3 Hz), it is preferred to apply a bar consisting of a composite in which a carbon rod is inserted into a tube made of silicon, a composite in which a plastic-ceramic composite rod mixed with a plastic rod (e.g., an ABS rod), ceramic and polymer is inserted into a tube made of Teflon, or a single body containing a metal rod such as aluminum.

The bar as described above bends the device by applying a force to the center of the device while moving up and down at a certain period at the upper and lower portions of the triboelectric power generating device when analyzing the electrical signals. For example, the bar may move up and down by 1 to 5 cm in a period of 1 to 20 hz, and when the up and down movement distance is 2 cm, the bar may move 1 cm in the upper direction and 1 cm in the lower direction. In addition, when analyzing the electrical signals, it is possible to secure reliability by measuring one set first and then measuring several additional sets after a pause of several to tens of seconds.

### 2. Protocol b)

Next, the electrical signal analysis protocol of b) is a method of analyzing electrical signals generated by holding at least one end of the triboelectric power generating device and then bending the central of the device into a predetermined curved surface. That is, in order to generate the electric signals, it is necessary to apply a physical effect to the triboelectric power generating device as described above (i.e., a physical effect of bending the device by applying a certain force), and in order to measure and analyze the generated electric signals, it is necessary to connect the signal analysis device to one end of each electrode (the description of the signal analysis device follows those described in the protocol a), which may be applied equally even to the protocol c) and Protocol d) to be described below). In addition, in order to measure the electrical signals more accurately by blocking external static electricity, a conductive material capable of inducing a Faraday cage effect may be used, and this also follows those described in the protocol a).

Meanwhile, when analyzing the electric signals, a pair of bars (or rods) for applying a force to the triboelectric power generating device at a certain period may be provided to be spaced apart at a predetermined interval from or bonded to the upper and lower portions of one end of the triboelectric power generating device. That is, one bar of the pair of bars may be positioned in an upper direction of the triboelectric power generating device, and the other bar may be positioned in a lower direction of the triboelectric power generating device, while being spaced apart at a certain distance from or bonded to the device.

The bar as described above moves up and down at a certain period at the upper and lower portions of the triboelectric power generating device when analyzing the electric signals, and thus, the bar induces the device to be bent up and down by applying a force to one end of the device (i.e., as a force is applied to one end of the device and the other end is fixed, the device is bent up and down). For example, the bar may move up and down by 1 to 5 cm at a period of 1 to 20 hz, and if the up and down movement distance is 4 cm, the bar may move up and down with the device by 2 cm. In addition, when analyzing the electrical signals, it is possible to secure reliability by measuring one set first and then measuring several additional sets after a pause of several to tens of seconds.

In addition, in the protocol b), the pair of bars may be provided to be spaced apart at a predetermined distance from or bonded to the upper and lower portions of each of both ends of the device instead of one end thereof. In this case, the device is bent (i.e., in a folded state) through the symmetrical movement of both ends to each other, and the electrical signals generated from this form are analyzed.

### 3. Protocol c)

Subsequently, the electrical signal analysis protocol of c) is a method of analyzing electrical signals generated by tapping and vibrating the device with a predetermined force and period while pressing the triboelectric power generating device without changing the shape thereof. That is, in order to generate the electric signals, it is necessary to apply a physical effect on the triboelectric power generating device as described above (that is, a physical effect of tapping or vibrating the device with a predetermined force), and in order to measure and analyze the generated electric signals, it is necessary to connect the signal analysis device to each electrode. In addition, in order to measure an electric signal more accurately by blocking external static electricity, a conductive material capable of inducing a Faraday cage effect may be used.

Since the protocol c) needs to analyze the electrical signals while maintaining the shape of the triboelectric power generating device in a circular shape, here, it is necessary to precede a process of fixing the shape of the device by placing and then pressing a high-strength plate on the upper and lower portions of the device. After such a process is performed, it is necessary to analyze the electric signals generated by inducing vibration by tapping at least one of the plates located at the upper and lower portions of the device with a certain period and force or by scratching the surface. The material of the plate may include, for example, iron, stainless steel, brass, and aluminum alloy, that may fix the device by pressing, and the strength thereof may be 0.001 to 100 kgf. In addition, the pressing force may be enough to be fixed so that the shape of the device is not changed, and therefore, there is no particular limitation on the pressing force. In addition, the force required to generate the electric signals or the degree of scratching is also not limited, such that the force or the degree of scratching may be appropriately varied according to a situation. In addition, when analyzing the electrical signals, it is possible to secure reliability by measuring one set first and then measuring several additional sets after a pause of several to tens of seconds.

### 4. Protocol d)

Finally, the electrical signal analysis protocol of d) is a method of analyzing electrical signals generated by shaking an inducer spaced apart at a certain distance from the triboelectric power generating device at a certain period. The protocol d) is a non-contact electrical signal analysis method that does not bend, tap or scratch the triboelectric power generating device, unlike the aforementioned protocols a) to c). Accordingly, in the protocol d) above, a conductive material that may induce a Faraday cage effect is not used so as to capture the movement of the device. In addition, the use of the signal analysis device connected to each electrode to measure and analyze the generated electrical signals is the same as the protocols a) to c) above.

More specifically, the inducer may be provided at a distance of several micrometers to several tens of meters from the device, and may generate electric signals by shaking at a certain period (e.g., 1 to 20 Hz) in various directions or shapes on a plane parallel to an evaluation surface of the device. The inducer is not particularly limited as long as the inducer is a member capable of generating electricity from the triboelectric power generating device, such as human's hands, metal rods, plastic rods made of PE, hair bundles, and cloth. In addition, as a direction or method of shaking the inducer, a horizontal direction, a vertical direction, a diagonal direction, and a circular shape may be exemplified based on the plane of the device, but there is no particular limitation as long as the direction or method is a direction or method that may generate electricity from the triboelectric power generating device. In addition, when analyzing the electrical signals, it is possible to secure reliability by measuring one set first and then measuring several additional sets after a pause of several to tens of seconds.

Hereinafter, the present invention will be described in more detail with reference to specific Examples. The following Examples are illustrative of the present invention and the present invention is not limited to the following Examples.

### [Example 1] Electric signal analysis of triboelectric generating device - Protocol a

First, a triboelectric power generating device was prepared in which electrodes were located on the upper and lower surfaces based on a triboelectric generating layer as the center, and then an electric signal analysis device, DMM 7510 (Keithley, USA) was connected to each electrode, and then the device was surrounded by aluminum foil. Next, one bar (a 8 mm-diameter silicon-made tube into which a 5 mm-diameter carbon rod was inserted) was provided at an interval of 1 mm in each of the upper and lower directions based on a longitudinal center of the device, and then moved up and down at a period of 1 to 12 hz by 1 cm (moving a total distance of 2 cm), and the device was bent by applying a force to the center of the device. At this time, the electric signals were measured by performing one set of force transfer first according to the movement of the bar as described above, and then, in order to improve reliability, the electric signals were measured after performing additional several sets after a pause for several to tens of seconds.

### [Example 2] Electric signal analysis of triboelectric generating device - Protocol b-1

A bar (a 8 mm-diameter silicon-made tube into which a 5 mm-diameter carbon rod was inserted) was provided at an interval of 1 mm in each of an upper direction and a lower direction of any one end instead of the center of the device, and an electric signal analysis device, DMM 7510 (Keithley, USA) was connected and fixed to one end of each electrode in the same direction. Thereafter, except that the device was bent up and down by applying a force to only one end of the device by moving the bar up and down at a period of 1 to 12 hz by 2 cm (moving a total distance of 4 cm), the electrical signals of the device were measured in the same manner as in Example 1.

### [Example 3] Electric signal analysis of triboelectric generating device - Protocol b-2

Except that a bar was provided at each of upper and lower portions of both ends of the device instead of one end of the device and the device was bent symmetrically by applying a force to both ends of the device, the electrical signals of the device were measured in the same manner as in Example 2.

### [Example 4] Electric signal analysis of triboelectric generating device - Protocol c

Except that as an example of applying a plate made of iron instead of a bar, two plates were placed on the upper and lower portions of the device, respectively, and then pressed with a weight of 2 kg to fix the device so that the shape of the device was not changed, and thereafter, electric signals were generated by tapping one plate with a force of 1 kg in a period of 1 to 10 hz, the electrical signals of the device were measured in the same manner as in Example 1.

### [Example 5] Electric signal analysis of triboelectric generating device - Protocol d

As a non-contact electrical signal analysis method, first, an electrical signal analysis device, DMM 7510 (Keithley, USA) was connected to each electrode of a triboelectric power generating device, a PE plastic rod (inducer) was positioned at a distance of 10 cm from the device, and then electric signals were generated by shaking the plastic rod at 1 to 10 Hz in a horizontal direction on a plane parallel to an evaluation surface of the device. Thereafter, the electric signals generated through such an inducer were measured by performing one set first, and then, in order to improve reliability, the electric signals were measured after performing additional several sets after a pause for several to tens of seconds.

### [Comparative Example 1] Electric signal analysis of triboelectric generating device

A triboelectric power generating device was prepared in which electrodes were located on the upper and lower surfaces based on a triboelectric generating layer as the center, and then electric signals generated by shaking the device at a certain period using a hand were measured.

### [Examples 1 to 5 and Comparative Example 1] Evaluation of electric signal analysis of triboelectric generating device

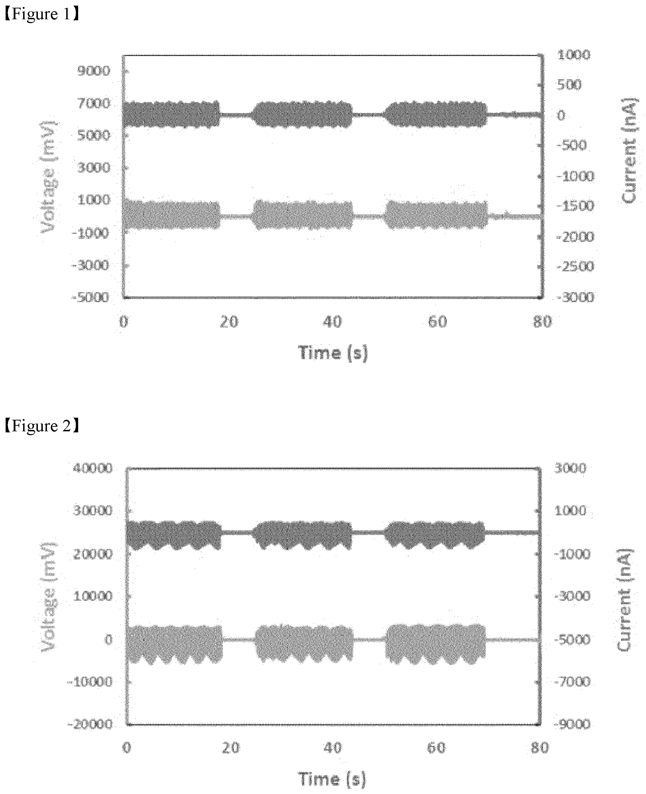

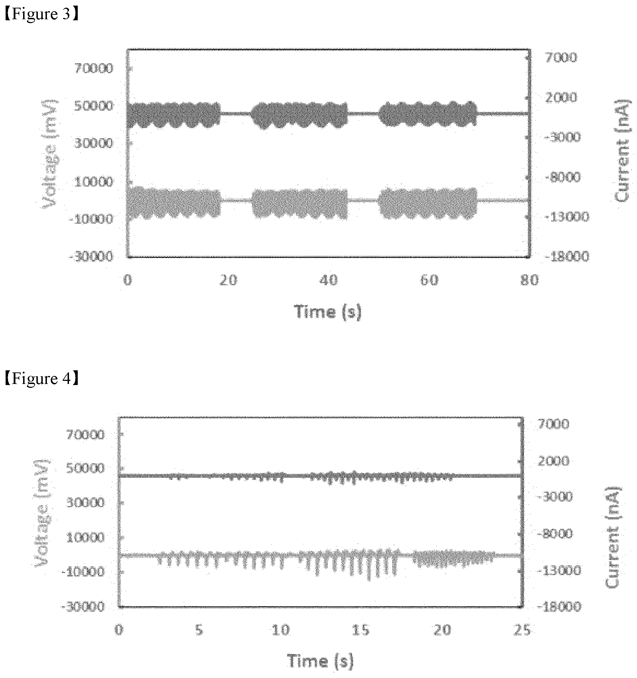

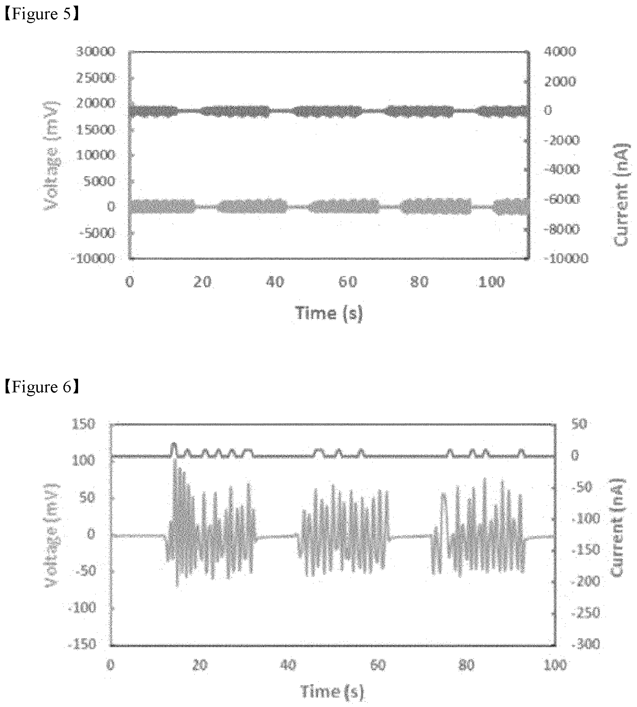

The electrical signals measured in each of Examples 1 to 5 and Comparative Example 1 were confirmed through a graphic sampling multimeter, DMM 7510 (Keithley, USA) (that is, confirmed changes in voltage/current according to stimulation applied to the device). FIGS. 1 to 5 are graphs of electrical signals of a triboelectric power generating device which are measured using protocols a) to d) according to an embodiment of the present invention and FIG. 6 is a graph of electrical signals of a triboelectric power generating device which are measured using a hand according to Comparative Example. Specifically, FIG. 1 is a graph of the electrical signals of the device measured in Example 1 (protocol a), FIG. 2 is a graph of the electrical signals of the device measured in Example 2 (protocol b-1), FIG. 3 is a graph of the electrical signals of the device measured in Example 3 (protocol b-2), FIG. 4 is a graph of the electrical signals of the device measured in Example 4 (protocol c), and FIG. 5 is a graph of the electrical signals of the device of Example 5 (protocol d).

As a result of confirming the electrical signals of the device through each signal analysis method as described above, in the case of using the protocols of Examples 1 to 5, as shown in FIGS. 1 to 5, electricity was immediately generated according to the impact/change applied to the device, and there was no significant difference in the amount of change in voltage/current, and thus, the performance of the device was measured very similarly. On the other hand, in the case of Comparative Example 1, which was measured by simply shaking by hand, the time intervals and intensities of the electrical signals were irregularly generated according to the impact/change applied to the device, and thus, it was difficult to evaluate objectively and equally the performance of the device as compared with the cases of using the protocols of Examples 1 to 5.

## Claims

1. An electric signal analysis method of a triboelectric power generating device comprising analyzing electrical signals of the triboelectric power generating device through at least one of the following protocols a) to d):
a) a protocol that analyzes electrical signals generated by applying a force to the center at a certain period so that the triboelectric power generating device is bent;
b) a protocol that analyzes electrical signals generated by applying a force to at least one end so that the triboelectric power generating device is bent;
c) a protocol that analyzes electrical signals generated by tapping the device at a certain period or causing vibration to the device within a limit without converting a shape of the triboelectric power generating device; and
d) a protocol that analyzes electrical signals generated by shaking an inducer spaced apart from the triboelectric power generating device at a predetermined distance.

2. The electric signal analysis method of the triboelectric power generating device of claim 1, wherein at a center of the device of the protocol a) and an end of the device of the protocol b), a pair of bars are provided to be vertically spaced apart from or bonded to the device, and the bar applies a force to the device through up and down movement.

3. The electric signal analysis method of the triboelectric power generating device of claim 2, wherein the bar has a diameter of 5 to 20 mm, and the bar is spaced apart from the device by 0.5 to 5 mm.

4. The electric signal analysis method of the triboelectric power generating device of claim 2, wherein the bar is selected from the group consisting of a composite in which a carbon rod is inserted into a silicon tube, a composite in which a plastic-ceramic composite rod mixed with a plastic rod, ceramic and polymer is inserted into a Teflon tube, and a single body containing a metal rod.

5. The electric signal analysis method of the triboelectric power generating device of claim 2, wherein the bar moves up and down by 1 to 5 cm in a period of 1 to 20 hz.

6. The electric signal analysis method of the triboelectric power generating device of claim 1, wherein a high-strength plate is provided on each of the upper and lower portions of the device in the protocol c) to prevent a shape change of the device.

7. The electric signal analysis method of the triboelectric power generating device of claim 6, wherein device electrical signals of the protocol c) are generated by tapping the plate or vibrating the plate.

8. The electric signal analysis method of the triboelectric power generating device of claim 6, wherein the material of the plate is selected from the group consisting of iron, stainless steel, brass and aluminum alloy, and the strength thereof is 0.001 to 100 kgf.

9. The electric signal analysis method of the triboelectric power generating device of claim 1, wherein the devices of the protocols a) to c) are provided inside a substrate made of a conductive material that causes a Faraday cage effect or surrounded by a conductor.

10. The electric signal analysis method of the triboelectric power generating device of claim 9, wherein the shape of the substrate is a box type or a mesh type, and the conductor is a plate-shaped conductive metal including aluminum foil.

11. The electric signal analysis method of the triboelectric power generating device of claim 1, wherein an inducer of the protocol d) is spaced apart at a distance of several micrometers to several tens of meters from the device, and is selected from the group consisting of human's hands, metal rods, plastic rods, hair bundles, and cloth.

12. The electric signal analysis method of the triboelectric power generating device of claim 1, wherein a direction or method of shaking the inducer is selected from the group consisting of a horizontal direction, a vertical direction, a diagonal direction, and a circle based on a plane of the device.

13. The electric signal analysis method of the triboelectric power generating device of claim 1, wherein a signal analysis device is connected to each electrode of the devices of the protocols a) to d).

14. The electric signal analysis method of the triboelectric power generating device of claim 1, wherein each of the protocols a) to d) is performed by performing one set and then performing additional several sets after a pause of several to tens of seconds.
